(19) Europäisches Patentamt
European Patent Office
Office européen des brevets

(11) **EP 2 019 438 A2**

(12) **DEMANDE DE BREVET EUROPEEN**

(43) Date de publication:
**28.01.2009 Bulletin 2009/05**

(51) Int Cl.:
***H01L 35/32*** *(2006.01)*

(21) Numéro de dépôt: **08290702.3**

(22) Date de dépôt: **18.07.2008**

(84) Etats contractants désignés:
**AT BE BG CH CY CZ DE DK EE ES FI FR GB GR HR HU IE IS IT LI LT LU LV MC MT NL NO PL PT RO SE SI SK TR**
Etats d'extension désignés:
**AL BA MK RS**

(30) Priorité: **23.07.2007 FR 0705331**

(71) Demandeur: **Commissariat à l'Energie Atomique 75015 Paris (FR)**

(72) Inventeurs:
• **Plissonnier, Marc 38320 Eybens (FR)**

• **Breton, Yannick 69002 Lyon (FR)**
• **Chartier, Isabelle 38000 Grenoble (FR)**
• **Lanier, Thierry 38200 Vienne (FR)**
• **Navone, Christelle 38430 Saint Jean de Moirans (FR)**

(74) Mandataire: **Corret, Hélène et al Cabinet Orès 36, rue de St Pétersbourg 75008 Paris (FR)**

(54) **Moyen thermoélectrique et structure de type tissu intégrant un tel moyen**

(57) L'invention concerne un moyen thermoélectrique (60) apte à être tissé ou tricoté se présentant sous la forme d'un corps allongé et comportant sur sa surface au moins un convertisseur d'énergie thermique en énergie électrique.

L'invention concerne également une structure de conversion en électricité d'une différence de température suivant l'épaisseur de ladite structure, constituée d'un assemblage par entrelacement de fibres textiles (8), desdits moyens thermoélectriques (60) et de moyens de connexion (7).

FIG.5

EP 2 019 438 A2

# Description

L'invention se situe dans le domaine des systèmes de récupération d'énergie appliqués aux tissus.

Elle concerne une structure du type tissu permettant la conversion en électricité d'une différence de température.

Il existe aujourd'hui des textiles dans lesquels sont intégrées des fonctions associées à des moyens électroniques. Ces fonctions consistent en la collecte d'informations sur l'environnement, grâce à des capteurs, tels que des capteurs de température, de pression atmosphérique, d'humidité ou encore de détection de présence, ou en la mesure de paramètres physiologiques (tels que la pulsation cardiaque, la température corporelle ou encore la pression artérielle).

Aujourd'hui, ces textiles à fonctions électroniques utilisent, comme source d'énergie, des accumulateurs au lithium qui doivent donc être prévus dans l'assemblage intégrant ce type de textiles.

Le principal inconvénient de ces textiles est donc qu'ils ne permettent pas une autonomie totale.

Pour surmonter cet inconvénient, il a déjà été proposé d'intégrer des convertisseurs thermoélectriques, sous la forme de fils, dans une structure textile.

De façon connue, un convertisseur thermoélectrique permet de convertir une énergie thermique en énergie électrique, en utilisant l'effet « Seebeck ». Ce principe est que, dans un circuit fermé constitué de deux conducteurs de nature différente, il circule un courant lorsqu'on maintient entre les deux jonctions une différence de température.

Un convertisseur thermoélectrique est constitué d'une pluralité de couples de deux conducteurs de nature différente. Les deux conducteurs d'un couple sont connectés en série électriquement et tous les couples de conducteurs sont connectés en série électriquement et en parallèle thermiquement. Ce montage permet d'optimiser le flux thermique qui traverse le convertisseur ainsi que sa résistance électrique.

Dans l'ensemble de la description, on comprendra par structure thermoélectrique une structure de conversion en électricité d'une différence de température.

On connaît déjà des structures thermoélectriques dans lesquelles sont intégrés deux conducteurs de nature différente. Ces conducteurs peuvent être tissés ou tricotés. Le tissage ou le tricotage permet de créer des connexions entre deux conducteurs de nature différente et donc de réaliser des couples de conducteurs ou thermocouples.

Ces conducteurs se présentent généralement sous la forme de fils réalisés en des métaux et/ou alliages qui présentent une ductilité suffisante pour permettre leur tissage ou leur tricotage.

Certaines structures prévoient d'intégrer un substrat en résine époxy, afin de garantir l'isolation électrique entre les conducteurs.

Dans les deux cas, les thermocouples sont connectés électriquement en série.

L'utilisation du tissage ou du tricotage, limite le type de matériaux pouvant être utilisés, ceux-ci devant se présenter sous forme de fils et être suffisamment souples.

De plus, certaines de ces structures permettent de convertir seulement une différence de température entre deux de leurs extrémités, considérées dans le plan de la structure, et non selon leur épaisseur. Elles ne permettent donc pas d'exploiter toute la chaleur émise par le corps humain lorsque la structure est utilisée pour réaliser un vêtement.

Par ailleurs, l'utilisation de fils en des matériaux ou alliages métalliques limite nécessairement les performances thermoélectriques de la structure obtenue, ces matériaux étant eux-mêmes peu performants. En tout état de cause, l'optimisation des performances thermoélectriques de la structure est limitée par les caractéristiques des métiers à tisser ou à tricoter, ces métiers imposant le diamètre des fils, l'épaisseur de la structure et également l'écartement des fils ou encore la dimension des mailles.

Enfin, lorsqu'un substrat isolant est utilisé, la structure obtenue est relativement rigide. Elle ne présente donc pas les caractéristiques d'un tissu et ne peut pas être utilisée directement pour réaliser un vêtement notamment.

On connaît également d'autres structures qui ne sont pas obtenues par tissage ou tricotage.

On peut notamment citer des générateurs d'énergie thermoélectrique utilisant également l'effet Seebeck et qui sont constitués de deux plaques ou feuilles entre lesquelles est disposée une thermopile. Les plaques ou feuilles peuvent être rigides ou flexibles. La thermopile peut être constituée par une feuille de polyimide sur laquelle des thermocouples sont connectés en série, cette feuille étant ensuite conformée pour prendre une forme ondulée.

Dans la mesure où ce thermogénérateur ne peut être ni tissé ni tricoté, il est nécessairement rapporté dans la structure qui intègre des fonctions électroniques. Lorsqu'il s'agit d'un vêtement, ceci modifie sa conception et son aspect final, dans la mesure où l'épaisseur d'un tel thermogénérateur est relativement importante, de l'ordre de 3 mm.

L'invention a pour objet de pallier les inconvénients présentés par les solutions de l'Etat de la Technique.

En particulier, l'invention concerne une structure thermoélectrique qui peut être directement utilisée pour réaliser une surface textile, avantageusement un vêtement et dont les performances thermoélectriques sont optimisées.

L'invention a donc pour objet une structure de conversion en électricité d'une différence de température suivant l'épaisseur de ladite structure ou encore entre ses deux faces, ladite structure étant constituée d'un assemblage par entrelacement de fibres textiles, de moyens thermoélectriques, capables de convertir une énergie thermique en électricité indépendamment de leur position dans ladite structure, et de moyens de connexion électrique.

De préférence, les fibres textiles sont diélectriques.

Les moyens thermoélectriques sont avantageusement connectés en parallèle par lesdits moyens de connexion.

Elle est basée sur l'utilisation de moyens thermoélectriques qui, avant leur assemblage dans la structure, présentent une fonctionnalité thermoélectrique. Ceci permet d'optimiser facilement les performances thermoélectriques de la structure en fonction des caractéristiques requises par les moyens électroniques qui nécessitent une alimentation électrique.

Ces moyens thermoélectriques sont donc réalisés au préalable, puis intégrés à l'aide de métiers à tisser au sein de la structure selon l'invention.

Ainsi, l'invention concerne un moyen thermoélectrique apte à être tissé ou tricoté, se présentant sous la forme d'un corps allongé et comportant sur sa surface au moins un convertisseur d'énergie thermique en énergie électrique.

De façon préférée, ledit au moins un convertisseur comporte des conducteurs électriques de nature différente de façon à définir au moins deux jonctions électriques, situées à des extrémités opposées desdits conducteurs et reliant électriquement en série lesdits conducteurs, lesdites au moins deux jonctions étant disposées de part et d'autre dudit corps selon la direction dans laquelle s'étend ledit corps.

Par ailleurs, le corps peut comprendre un support isolant thermique et flexible, sur lequel est fixé et plié ledit au moins un convertisseur.

Ce support peut présenter une forme de ruban à section sensiblement rectangulaire, ledit convertisseur étant sensiblement en forme de U.

Dans un mode avantageux de réalisation, ledit au moins un convertisseur comporte une pluralité de thermocouples mis en série électriquement et en parallèle thermiquement, ces thermocouples étant disposés sur un substrat isolant électrique, lequel est plié transversalement aux thermocouples.

Le substrat peut se présenter sous la forme d'une feuille polymère, avantageusement du polyimide, du polyéthylène, du polyamide, ou du polyester.

Dans un mode préféré de réalisation, les thermocouples sont sous forme de couches minces de matériaux thermoélectriques tels que Bi, Sb, $Bi_2Te_3$, des alliages à base de Bi et Te, Sb et Te, ou encore Bi et Se, ou encore des super-réseaux Si/SiGe.

Le support peut présenter la forme d'un ruban en un matériau choisi parmi les fibres textiles et/ou des matériaux polymères tels que polyimide, polyéthylène, polyamide ou polyester.

Le convertisseur peut comporter des jonctions électriques sur chacune des deux faces du substrat.

L'invention sera mieux comprise et d'autres buts, avantages et caractéristiques de celle-ci apparaîtront plus clairement à la lecture de la description qui suit et qui est faite au regard des dessins annexés, sur lesquels :

- la figure 1 représente schématiquement un convertisseur thermoélectrique illustrant l'effet Seebeck ;
- la figure 2 représente une étape de fabrication d'un moyen thermoélectrique selon l'invention ;
- la figure 3 représente une autre étape de fabrication d'un moyen thermoélectrique selon l'invention ;
- la figure 4 représente une variante de réalisation d'un moyen thermoélectrique selon l'invention ;
- la figure 5 illustre un exemple de structure conforme à l'invention ; et
- la figure 6 est un schéma électrique modélisant la structure illustrée à la figure 5.

Les éléments communs aux différentes figures seront désignés par les mêmes références.

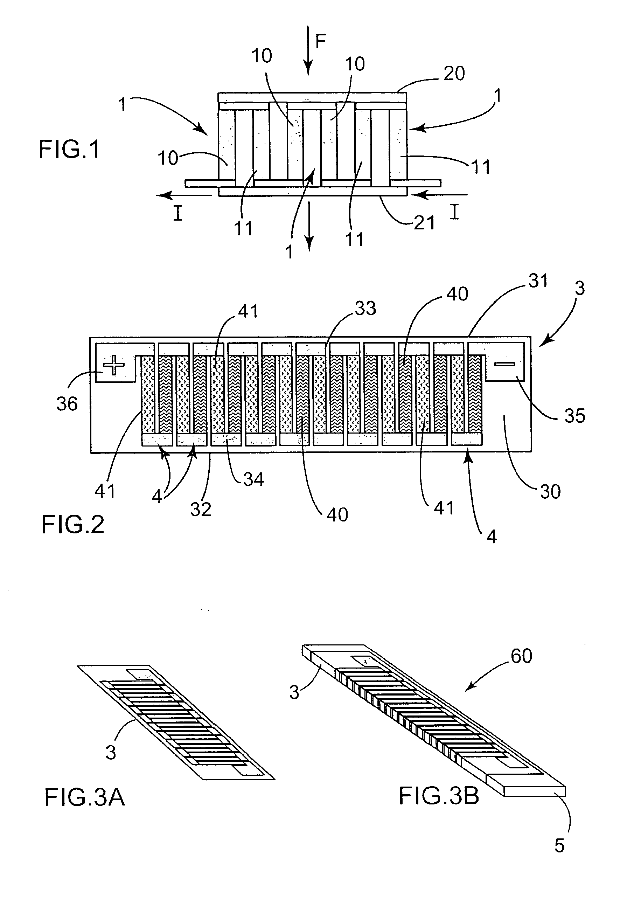

On se réfère tout d'abord à la figure 1 qui illustre un convertisseur thermoélectrique constitué ici de trois couples 1 de conducteurs connectés électriquement. Chaque couple comprend deux conducteurs électriques 10, 11 de nature différente.

Comme l'illustre la figure 1, les deux conducteurs 10, 11 d'un même couple 1 sont connectés en série électriquement, les couples 1 étant par ailleurs également connectés en série électriquement. Le courant circulant à l'intérieur du convertisseur est schématisé par I.

Enfin, les couples de conducteurs sont connectés en parallèle thermiquement. Dans l'exemple illustré à la figure 1, il existe une différence de température entre la face chaude 20 et la face froide 21 du convertisseur thermoélectrique, qui est traversé par un flux de chaleur illustré par la flèche F.

Le rendement d'un tel convertisseur est directement proportionnel à une différence de température appliquée entre les deux faces du convertisseur.

On se réfère maintenant à la figure 2 qui illustre la première étape de fabrication d'un moyen thermoélectrique 3 selon l'invention.

La figure 2 illustre un substrat souple, sensiblement plan et allongé 30 sur lequel ont été déposés les couples 4 de conducteurs ou thermocouples, chacun constitué de deux conducteurs 40, 41 de nature différente. Ils s'étendent sensiblement perpendiculairement à la direction longitudinale du substrat.

Les conducteurs 40, 41 de chaque couple, ainsi que tous les couples 4, sont connectés en série électriquement, au moyen de jonctions 33, 34 situées le long de chaque face longitudinale 31, 32 du substrat. Lorsqu'une différence de température est appliquée entre les deux faces 31, 32, un courant électrique est généré entre les deux bornes 35, 36.

La réalisation des conducteurs pourra être effectuée à l'aide de masques mécaniques ou de technique de photolithographie et de gravure.

Par ailleurs, les couples de conducteurs, réalisés sous la forme de films minces sont connectés en parallèle thermiquement.

Si un flux de chaleur traverse le moyen thermoélectrique depuis la face 31, vers la face 32, de telle sorte qu'une différence de température apparaisse entre ses deux faces, la face 31 sera dénommée face chaude et la face 32 face froide. De même, les jonctions 33 seront dénommées jonctions chaudes et les jonctions 34, jonctions froides.

De façon générale, la tension Seebeck $U_s$ du moyen thermoélectrique 3 dépend du nombre de thermocouples connectés et de la différence de température entre chacune des faces 31, 32 du moyen thermoélectrique, ou encore entre les jonctions 33, 34 à chaque extrémité des conducteurs.

$$U_S = nS_{couple}\Delta T,$$

où

$U_S$ : la tension Seebeck du dispositif,
n : le nombre de thermocouples connectés,
$S_{couple}$ : le coefficient du couple thermoélectrique choisi, et
$\Delta T$ : la différence de température entre les jonctions 33, 34 à chaque extrémité des couples 4 de conducteurs.

Ainsi, pour une différence de température donnée, seul le nombre et la nature des thermocouples connectés permettront de définir la tension désirée.

Enfin, l'optimisation du rapport section/longueur des conducteurs permet une première optimisation de leur résistance.

La figure 3 représente, en perspective, la feuille thermogénératrice illustrée à la figure 2 (figure 3A) ainsi que cette même feuille 3, après pliage et collage autour d'un support 5, pour obtenir un moyen thermoélectrique 60 selon l'invention.

Dans l'exemple illustré à la figure 3, le support 5 prend la forme d'un ruban tissable ou encore d'une laminette. Ce support pourrait également se présenter sous la forme d'un fil. Il est évident aussi que le support pourrait être supprimé ; il suffit pour cela que le substrat soit suffisamment rigide que la structure en U tienne par elle-même.

Le terme laminette est bien connu dans le domaine du textile et peut être défini comme une bande continue et étroite, d'épaisseur faible par rapport à sa largeur, obtenue par découpe de film ou filage direct.

Dans tous les cas, le support est isolant et flexible et est de forme allongée.

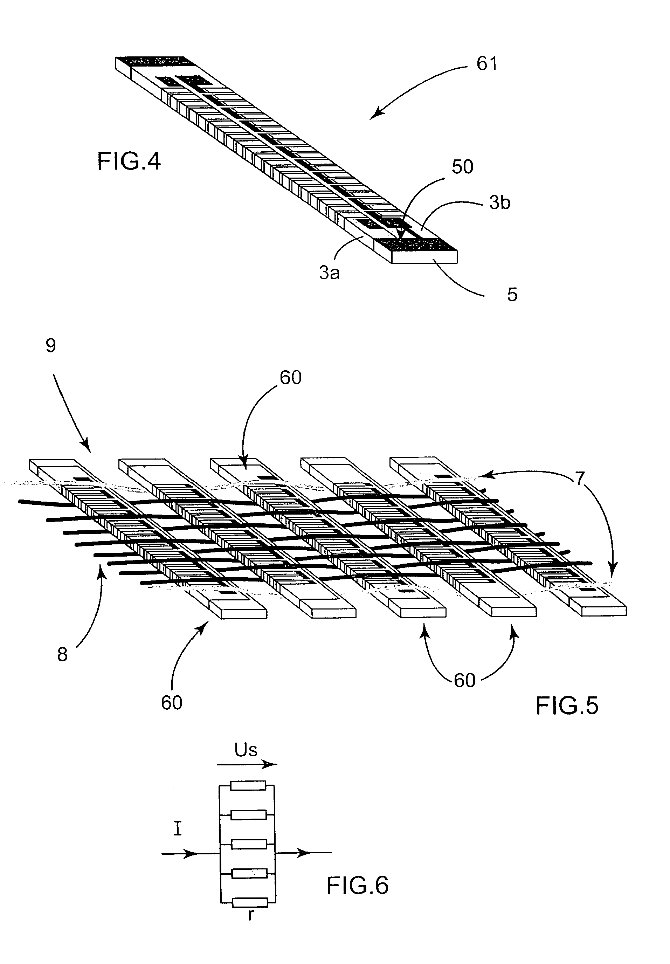

La figure 4 représente une variante de réalisation d'un moyen thermoélectrique selon l'invention, dans laquelle deux feuilles thermogénératrices 3 sont pliées et fixées sur un même support isolant 5.

En pratique, le moyen thermoélectrique 61 illustré à la figure 4 peut être réalisé à partir du moyen 60 illustré à la figure 3. Il suffit, pour cela, de plier et de coller autour du support 5, une autre feuille 3, de façon symétrique selon un axe médian longitudinal du support 5, par rapport à la première feuille thermogénératrice.

Le moyen thermoélectrique 61, comporte ainsi deux feuilles thermogénératrices 3a et 3b, disposées tête-bêche ou encore symétriquement par rapport à un axe longitudinal médian du support 5, un dépôt métallique 50 pouvant être prévu sur le support 5 afin d'assurer une connexion électrique entre les deux feuilles 3a et 3b.

Une autre façon d'optimiser la surface consiste à superposer d'un même côté plusieurs moyens électriques connectés en série ou en parallèle, l'isolation entre eux étant assurée par le substrat.

On peut enfin aussi envisager de réaliser les moyens thermoélectriques sur chacune des faces du substrat.

Avec cette variante de réalisation, on obtient une optimisation de la surface utile, en augmentant le nombre de couples de conducteurs.

En ce qui concerne tout d'abord les matériaux thermoélectriques permettant de réaliser les conducteurs, il convient de rappeler que le rendement théorique d'un générateur thermoélectrique ou d'un refroidisseur thermoélectrique dépend directement d'un coefficient sans dimension ZT. Ce coefficient, appelé facteur de mérite, est égal à $S^2\sigma T/K$ où S est le coefficient Seebeck, $\sigma$ la conductivité électrique, K la conductivité thermique et T la température absolue.

Un rendement élevé nécessite des matériaux avec un coefficient ZT important et donc une conductivité électrique élevée, afin de réduire au minimum le chauffage par effet joule lorsque le courant électrique passe dans le matériau ; une conductivité thermique faible, afin de réduire le phénomène de pont thermique entre la partie chaude et la partie froide du générateur ou du refroidisseur et un coefficient Seebeck élevé, pour une conversion optimale de la chaleur en courant électrique.

Plus le facteur de mérite sera élevé, plus les performances du dispositif seront grandes. Ainsi, le choix des matériaux déposés, ainsi que la structure choisie (films minces ou super réseau), vont définir le facteur de mérite ZT, donc les performances électriques.

Actuellement, les meilleurs matériaux thermoélectriques ont une valeur de ZT de 1 environ, pour une gamme de température donnée.

Comme en témoignent divers travaux, la nature des matériaux thermoélectriques pouvant être déposés sur un substrat souple est extrêmement large : métaux, alliages métalliques mais également matériaux thermoélectriques présentant les meilleures performances telles que Bi, Sb, $Bi_2Te_3$, voire même des super-réseaux Si/SiGe. Le choix des matériaux sera réalisé suivant le coût, le critère toxicologique exigé et les performances électriques désirées.

L'invention permet d'utiliser tout type de matériaux thermoélectriques, tels que des alliages de type $Bi_xTe_y$, $Sb_xTe_y$ et $Bi_xSe_y$ matériaux présentant les meilleures performances thermoélectriques à 300K ou SiGe, matériau biocompatible, ou les skutterudites de terres rares.

Il est également possible d'envisager de déposer des super réseaux qui permettent d'augmenter le facteur de puissance $S^2\sigma$, tout en abaissant fortement la contribution des phonons du réseau cristallin par des effets de taille quantique des super-réseaux. Ainsi, il est possible d'envisager des super réseaux de type $Bi_2Te_3/Sb_2Se_3$ (dont le facteur de mérite est de *3 environ),* PbTe/PbTeSe (« quantum dot », dont le facteur de mérite est d'environ 2), Si/Ge (dont le facteur de mérite est de 3 environ) ou encore de n-Si/SiGe et p- $B_4C/B_9C$.

De façon classique, le terme « super-réseau » couvre un empilement de couches successives très fines (dont l'épaisseur est inférieure à 10 nm) et le terme « quantum dot » désigne une inclusion d'agrégats de taille nanométrique dans un autre matériau.

Des nanoparticules de semi-conducteurs (nano-inclusions) ayant une structure de bande semblable à celle du matériau thermoélectrique, peuvent être intégrées dans le dépôt. Elles ont pour effet l'augmentation du facteur de mérite ZT et donc des performances du thermogénérateur. Ainsi, dans un dépôt de Ge ou SiGe, des inclusions de Si ou SiGe peuvent être incorporées (ou inversement des nanoparticules de Ge peuvent être incorporées dans une matrice de silicium). La matrice et le matériau d'inclusion pourront être dopés de type-n ou de type p. Généralement, la concentration des dopants sera optimisée pour les différentes combinaisons de matériaux envisagés.

Il est également possible de réaliser des combinaisons avec des matériaux « hôtes » de type SiGe, PbTe ou $Bi_2Te_3$ incorporant des inclusions de PbSe, PbSeTe ou encore $Sb_2Te_3$ (ou vice versa). D'autres matériaux envisageables sont PbSn ou des alliages PbTeSeSn. Les matériaux du groupe III-V pourront être également utilisés ainsi que dès systèmes HgCdTe, Bi ou BiSb.

Les films minces seront déposés par des techniques de dépôt telles que la pulvérisation cathodique, l'évaporation, la PECVD ou encore des techniques de sérigraphie ou d'imprimerie (jet d'encre, héliographie, flexographie).

Comme indiqué en référence à la figure 2, le substrat 30 est sensiblement plan et flexible. Il est également préférable qu'il soit de faible épaisseur et de faible conductivité thermique et électrique.

Suivant les techniques de dépôt choisies et l'application visée, une haute stabilité thermique et chimique pourra être également nécessaire.

Le substrat le mieux adapté est en polymère par exemple une feuille de polyimide (commercialisé par exemple sous la marque Kapton ®), puisque ce matériau présente une combinaison unique de l'ensemble des propriétés nécessaires pour un large choix d'applications. Cependant, d'autres matériaux tels que polyester, polyéthylène, polyamide, polystyrène, polypropylène, polycarbonate peuvent être envisagés comme substrat, mais aussi du papier.

Le matériau utilisé pour réaliser les jonctions électriques entre les conducteurs présente une forte conductivité électrique, afin de minimiser les résistances de contact et également une forte conductivité thermique, pour assurer un bon couplage thermique.

En ce qui concerne le support 5 pour la feuille thermogénératrice, le choix de son épaisseur et de sa nature permettra de garantir le gradient thermique entre les deux faces du moyen thermoélectrique obtenu.

Le support est de façon préférée une laminette ou un ruban de section rectangulaire. La largeur ainsi que l'épaisseur de la laminette peut varier d'une centaine de micromètre au millimètre. Le choix de l'épaisseur sera fonction de la différence de température désirée, sachant que $\Delta T = \Phi\left(\dfrac{e}{\lambda}\right)$ avec « $\Phi$ » le flux thermique traversant le textile, « e » l'épaisseur de la laminette et « $\lambda$ » la conductivité thermique de la laminette.

La longueur du ruban ou du fil sera définie par la dimension du textile désirée. Toute la longueur du fil/laminette pourra être utilisée pour assembler un grand nombre de thermoéléments et par conséquent, permettre l'obtention de la tension désirée.

Il est également possible d'envisager un empilement de quelques feuilles thermogénératrices comme illustré à la figure 4, afin d'augmenter le nombre de thermoéléments en série et donc la tension, et par conséquent, d'augmenter la densité de puissance utile. Le fait que le substrat utilisé pour le dépôt des matériaux thermoélectriques soit très fin, permet de ne modifier que légèrement l'épaisseur de la laminette et donc la taille du moyen thermoélectrique selon l'invention.

On se réfère maintenant à la figure 5 qui illustre un exemple de structure thermoélectrique selon l'invention.

Cette structure est réalisée à partir de moyens thermoélectriques, tels que le moyen 60 illustré à la figure 3B, de fils conducteurs 7 et de fils isolants 8. Ainsi, cette structure est constituée d'un assemblage par entrelacement de ces différents éléments.

En pratique, cet assemblage est réalisé, directement, au moyen d'un outil à tisser ou à tricoter. Tous les éléments constitutifs de la structure sont ainsi tissés et tricotés simultanément.

Les fils conducteurs 7, typiquement des fils métalliques, permettent de connecter en parallèle les moyens thermoélectriques 60. Pour cela, les contacts entre les fils conducteurs 7 et les moyens thermoélectriques 60 se font de façon alternée entre les deux faces de la structure 9.

La tension Seebeck de la structure selon l'invention est fixée par le nombre de thermocouples liés en série sur un moyen thermoélectrique 60. De plus, la résistance électrique de la structure selon l'invention peut être optimisée par la mise en parallèle des moyens thermoélectriques 60.

Si l'application désirée requiert un courant I, le nombre x de moyens thermoélectriques, ayant une résistance r, liés en parallèle sera de : $x = rI/U_S$ où $U_S$ est la tension Seebeck de la structure.

La figure 6 représente le schéma électrique correspondant à la structure selon la figure 5. Ainsi, chaque moyen thermoélectrique 60 a une résistance r. Ils sont tous connectés en parallèle électriquement et ici, 5 $U_S$ = rI.

Ce sont les fils textiles 8 ainsi que les fils de connexion 7 qui assurent le maintien mécanique de la structure selon l'invention. Les fils 8 assurent en plus l'isolation entre les moyens thermoélectriques 60.

Un exemple de réalisation d'une structure thermoélectrique selon l'invention est donné ci-dessous.

Il utilise des alliages thermoélectriques à base de $Bi_2Te_3$ de type n et de type p pour réaliser des thermocouples sur un substrat. Les caractéristiques thermoélectriques de ce couple sont: $\lambda$ = 1,5 W/mK, $\rho$ = 2,5 m$\Omega$cm et S = 400$\mu$m V/K. Ainsi, pour une laminette de 25 $\mu$m d'épaisseur, d'1 mm de largeur et de longueur de 1 m, il est possible de connecter 1000 thermoéléments de 500$\mu$m de large espacés de 500$\mu$m, soit 500 thermocouples. L'empilement de quatre feuilles thermogénératrices permettra, pour une différence de température $\Delta T$ de 1,3°C, d'obtenir une tension de 1V.

Afin d'obtenir un courant de 10 mA, il est nécessaire de mettre 370 laminettes en parallèle. Ceci sera réalisé à l'aide de métier à tisser ou à tricoter (par exemple le mode RACHEL TRAMER).

On comprend que les avantages apportés par l'invention sont nombreux.

L'invention permet tout d'abord la réalisation de moyens thermoélectriques qui permettent de convertir une énergie thermique en électricité, avant même qu'ils ne soient assemblés dans la structure finale.

Par ailleurs, grâce à l'invention, une structure thermoélectrique peut être obtenue par tissage ou tricotage simultané, à la fois des fibres textiles, des moyens thermoélectriques et des fibres de connectique.

La structure obtenue permet d'exploiter la différence de température entre ses deux faces. Ainsi, la surface active de la structure obtenue est de même ordre de grandeur que la surface du vêtement réalisé avec elle. En conséquence, l'énergie électrique fournie peut être significative, toute la chaleur émise par le corps humain pouvant être utilisée.

La connexion électrique est réalisée de façon simple, par l'intermédiaire de fils conducteurs. Elle permet d'optimiser facilement les caractéristiques thermoélectriques de la structure, en fonction de l'application.

Par ailleurs, le rendement global de la structure selon l'invention peut être augmenté en utilisant des matériaux thermoélectriques très performants.

Enfin, la structure selon l'invention garde un aspect de textile, souple, respirant, conformable (moulable, injectable) et confectionnable et son épaisseur peut être faible, car elle sera compensée par la surface importante et un choix approprié des matériaux électriques.

Cette structure peut être aussi utilisée comme revêtement de tout dispositif plus chaud que l'air ambiant (chaudière, tuyauterie, ...) afin de récupérer de l'énergie.

Elle peut aussi être associée à un autre matériau durcissable (par exemple une résine) afin d'obtenir un composite présentant des propriétés thermoélectriques, facilement adaptable à la forme souhaitée (par exemple en aile d'avion).

Les signes de référence mentionnés après les caractéristiques techniques figurant dans les revendications ont pour seul but de faciliter la compréhension de ces dernières et ne sauraient en limiter la portée.

## Revendications

**1.** Moyen thermoélectrique (60, 61) apte à être tissé ou tricoté, se présentant sous la forme d'un corps allongé et comportant sur au moins une de ses surfaces au moins un convertisseur (3) d'énergie thermique en énergie électrique, **caractérisé en ce que** ledit au moins un convertisseur est plié pour former une structure en U.

**2.** Moyen thermoélectrique selon la revendication 1, dans lequel ledit au moins un convertisseur (3) comporte des conducteurs électriques (40, 41) de nature différente de façon à définir au moins deux jonctions électriques (33, 34), situées à des extrémités opposées desdits conducteurs et reliant électriquement en série lesdits conducteurs, lesdites au moins deux jonctions étant disposées de part et d'autre dudit corps selon la direction dans laquelle s'étend ledit corps.

**3.** Moyen thermoélectrique selon la revendication 1 ou 2, le corps comprenant un support (5) isolant thermique et flexible, sur lequel est fixé et plié ledit au moins un convertisseur (3).

**4.** Moyen thermoélectrique selon la revendication 3, dans lequel ledit support (5) présente une forme de ruban à section sensiblement rectangulaire et ledit convertisseur (3) est sensiblement en forme de U.

**5.** Moyen thermoélectrique selon l'une des revendications 1 à 4, dans lequel ledit au moins un convertisseur (3) comporte une pluralité de thermocouples (4) mis en série électriquement et en parallèle thermiquement, lesdits thermocouples étant disposés sur un substrat isolant électrique (30), plié transversalement aux thermocouples (4).

6. Moyen thermoélectrique selon la revendication 5, dans lequel ledit substrat (30) est une feuille de polymère, avantageusement du polyimide, du polyéthylène, du polyamide ou du polyester.

7. Moyen thermoélectrique selon la revendication 5 ou 6, dans lequel les thermocouples sont sous forme de couches minces de matériaux thermoélectriques tels que Bi, Sb, $Bi_2Te_3$, des alliages à base de Bi et Te, Sb et Te, ou encore Bi et Se, ou encore des super-réseaux Si/SiGe.

8. Moyen thermoélectrique selon l'une des revendications 5 à 7, dans lequel le support (5) présente la forme d'un ruban en un matériau choisi parmi les fibres textiles et/ou des matériaux polymères, avantageusement du polyimide, du polyéthylène, du polyamide ou du polyester.

9. Moyen thermoélectrique selon l'une des revendications 5 à 8, dans lequel, le convertisseur comporte des jonctions sur chacune des deux faces du substrat (30).

10. Structure de conversion en électricité d'une différence de température suivant l'épaisseur de ladite structure, constituée d'un assemblage par entrelacement de fibres textiles (8), de moyens thermoélectriques (60, 61) selon l'une des revendications 1 à 9, capables de convertir une énergie thermique en électricité indépendamment de leur position dans ladite structure, et de moyens de connexion électrique (7).

11. Structure selon la revendication 10, dans laquelle les fibres textiles sont diélectriques.

12. Structure selon la revendication 10 ou 11, dans laquelle lesdits moyens thermoélectriques (60, 61) sont connectés en parallèle par lesdits moyens de connexion (7).

**FIG.1**

**FIG.2**

**FIG.3A**

**FIG.3B**

**FIG.4**

61

50

3b

3a

5

9

60

7

8

60

60

**FIG.5**

Us

I

r

**FIG.6**